# EUROPEAN PATENT APPLICATION

(11) **EP 1 376 681 A2**
(43) Date of publication of application: **02.01.2004**
(21) Application number: 03254075.9
(22) Date of filing: 26.06.2003
(51) Int. Cl.: H01L 21/66, G01R 31/00

(54) **Data analysis apparatus**

(30) Priority: 26.06.2002 JP 2002186747
(71) Applicant: Agilent Technologies, Palo Alto, CA 94303-0870 (US)
(72) Inventor: Tamura, Hiroshi, Tokyo, Japan 192-0045 (JP)
(74) Representative: Hackett, Sean James

(57) **Abstract**

A data analysis apparatus (100) having a graph display device (122) that displays a graph of data that are the subject of display, a map display device (124) pertaining to the test position of data that are the subject of display, and a graph element selection device (116), with which the desired graphed data on the graph display device (122) are selected and the mapped data on the map display device (124) relating to the data that have been selected are displayed in highlighted form, or a data analysis apparatus (100) further comprising a map element selection device (118), with which the desired data on the map display device (124) are selected and graphed data on the graph display device (122) related to the mapped data that have been selected are displayed in highlighted form.

## Description

### BACKGROUND OF THE INVENTION

### 1. Field of the Invention

The present invention relates to a test data analysis apparatus for semiconductor wafer processes.

### 2. Discussion of the Background Art

Conventional technology is known whereby semiconductors are inspected and this inspection data are analyzed and feedback is sent to the production processes in order to maintain or improve production quality in semiconductor production processes. For instance, it is published in Japanese Patent Publication No. 10[1998]-303,267 that graph display and wafer map display are forms in which analysis results are displayed and further, that analysis proceeds by repeating a series of processes involving search and extraction of data that are the subject of analysis, display of analysis results, and study of the details.

By means of this type of conventional analysis apparatus, the operator can study test data by comparing data that has been graphed and data that has been displayed on a wafer map. However, there is a disadvantage in that it is not possible to easily confirm which test point on the graph corresponds to data that has been tested with a die at a certain position on the wafer map. That is, it is necessary to perform a series of operations involving data extraction and analysis and a display of results, or to search data that have been analyzed, and confirm a corresponding relationship between the graph and the wafer map when the operator determines that further analysis is necessary. Therefore, analysis takes time and the source of a problem cannot be successfully specified.

### SUMMARY OF THE INVENTION

In light of the above-mentioned problem points, the inventors of the present application realized that it is beneficial in terms of analysis of semiconductor production processes and feedback that the operator performing this type of analysis is able to easily know the tendency of test data in relationship to information on the position on the wafer during the test.

That is, the object of the present invention is to present a data analysis apparatus with which the tendency of a graph display of test data can be easily known in relationship to the tendency of a map display.

Another object is to present a data analysis apparatus with which, when any data on either a graph display or a map display of test data are selected, data corresponding to the data that have been selected are displayed in highlighted form on the other display.

Yet another object is to present a data analysis apparatus with which, when one or more desired elements of test data are selected from a graph display of test data, the position data corresponding to the selected test data elements are displayed in highlighted form on a map display of the test data.

Still another object is to present a data analysis apparatus with which, when one or more desired elements of position data are specified in the map display of test data, test data relating to the selected position data elements are displayed in highlighted form on a graph display of test data.

The data analysis apparatus of a first embodiment of the present invention comprises a graph display device that displays a graph of data that are the subject of display, a map display device pertaining to the test position of the data that are the subject of display, and a graph element selection device, with which the desired graphed data on the graph display device are selected and the mapped data on the map display means related to these data that have been selected are displayed in highlighted form.

The data analysis apparatus of a second embodiment of the present invention comprises a graph display device that displays a graph of the data that are the subject of display, a map display device pertaining to the test position of the data that are the subject of display, and a map element selection device, with which the desired data on the map display device are selected and the graphed data on the graph display device related to these mapped data that have been selected are displayed in highlighted form.

By means of a third embodiment of the present invention, the first embodiment further comprises a map element selection device with which the desired data on the map display device are selected and the graphed data on the graph display device related to these mapped data that have been selected are displayed in highlighted form.

The data here include test data and processing results data obtained by analytical processing based on test data. Furthermore, the graphing by the graph display device includes graph forms, such as two-dimensional or three-dimensional graphs, for instance, scatter plots, line graphs, bar graphs, circle graphs, cumulative distribution plots, etc. Moreover, mapping forms with which information on the physical position of elements attributed to data are displayed, such as wafer maps, die maps, etc., are included in the mapping by the map display device.

### BRIEF DESCRIPTION OF THE DRAWINGS

Figure 1 is a schematic diagram showing an exemplary embodiment of the present invention;
Figure 2 is a schematic diagram of the screen display of the exemplary embodiment in Figure 1;
Figure 3 is a schematic diagram of an example of the display by the graph display window in Figure 2;
Figure 4 is a schematic diagram of an example of the display by the map display window in Figure 2;
Figure 5 is a schematic diagram of another example of the display by graph display part 310 of the graph display window in Figure 3 showing as display part 510;
Figure 6 is a schematic diagram of another example of the display by map display part 410 of the map display window in Figure 4 showing as display part 610;
Figure 7 is a flow chart showing operation of the graph element selection device of the embodiment in Figure 1; and
Figure 8 is a flow chart showing operation of the map element selection device of the embodiment in Figure 1.

### DETAILED DESCRIPTION OF THE INVENTION

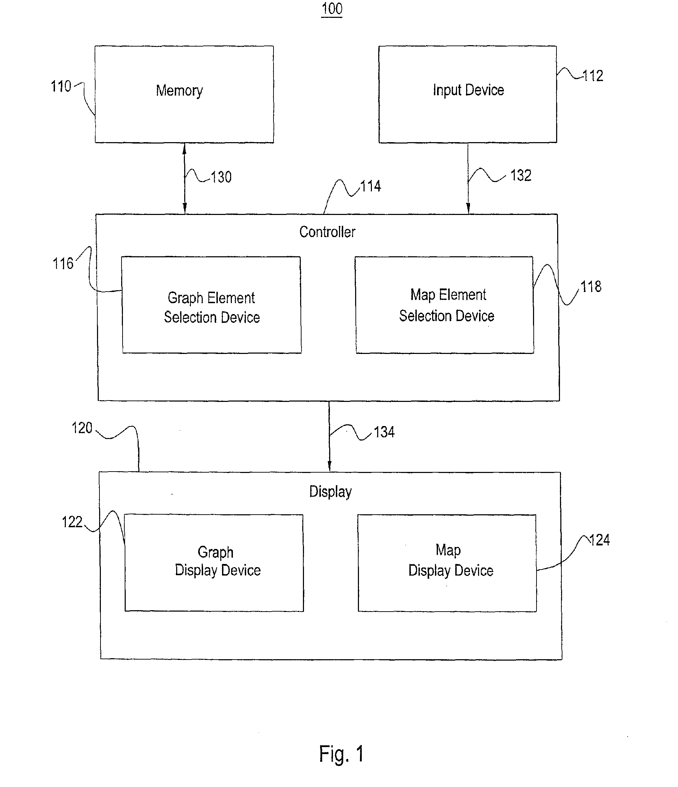

A block diagram of data analysis apparatus 100 (for semiconductor tests), which is an exemplary embodiment of the present invention, is shown in Figure 1. Data analysis apparatus 100 provides controller 114, display 120, memory 110, and input device 112. Display 120 includes a display device, such as a CRT or a liquid crystal display (LCD), etc., and receives displayed data from the controller 114. Memory 110 has a temporary memory device, such as a volatile memory device, etc., and/or a permanent memory device, such as a hard disk, etc., and is controlled by controller 114. Input device 112 has a pointing device, such as a mouse, etc., and/or a keyboard, and sends data input from the ' operator or instructions input by the pointing device to the control part. The controller performs processing based on the data or instructions from input device 112 and/or memory 110 and displays these results on display 120.

Display 120 further provides graph display device 122 and map display device 124. Graph display device 122 has the function of displaying data that are the subject of display on the desired type of graph. The types of graphs that are displayed include, for example, a scatter plot, line graph, bar graph, circle graph, cumulative distribution plot, etc.

Map display device 124 has the function of mapping information on the physical position of data that are the subject of display. The maps that are displayed include wafer maps, die maps, etc.

Controller 114 further has graph element selection device 116 and map element selection device 118. Graph element selection device 116 has the function of selecting one or multiple display elements that have been graphed by graph display device 122 in conjunction with input device 112 and memory 110 based on operator operation. Moreover, it also has the function of sending to graph display device 122 instructions that are displayed in highlighted form so as to differentiate the elements that have been selected from the other elements.

The phrase "displayed in highlighted form" here means a display method, for example, such that the elements that have been selected are differentiated from the other elements, and it includes displaying with different colors, displaying with colors that are the reverse of the original display colors, or displaying with a drawing pattern that is different from the others, for instance, displaying by shading or with a striped pattern or speckled pattern.

Map element selection device 118 has the function of selecting one or multiple map elements that have been mapped by map display device 124 in conjunction with input device 112 and memory 110 based on operator operation. Moreover, it also has the function of sending to map display device 124 instructions that are displayed in highlighted form such that the elements that have been selected are differentiated from the other elements.

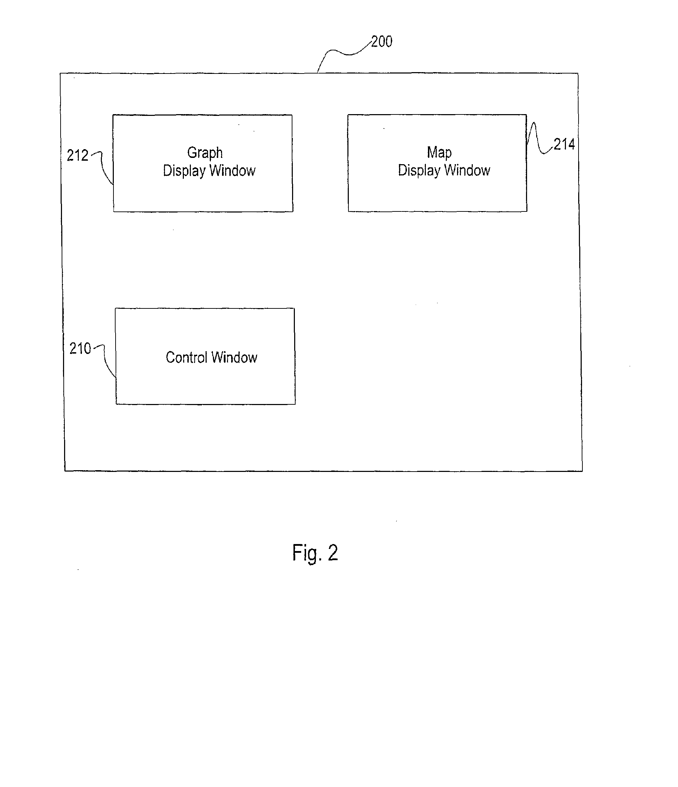

The operation of data analysis apparatus 100 will be explained using Figures 2 through 6. Figure 2 is a drawing showing an outline of the entire screen display of the present invention. Graph display window 212 is displayed by graph display device 122, map display window 214 is displayed by map display device 124, and console window 210, which controls the operation of each of the other functions of data analysis apparatus 100, are displayed on screen 200, which is displayed on a CRT or liquid crystal by display 120.

By way of illustration, the console window is shown as a separate window here, but those skilled in the art can imagine a variety of forms for the console window, including forms that incorporate the graph display window and map display window, etc.

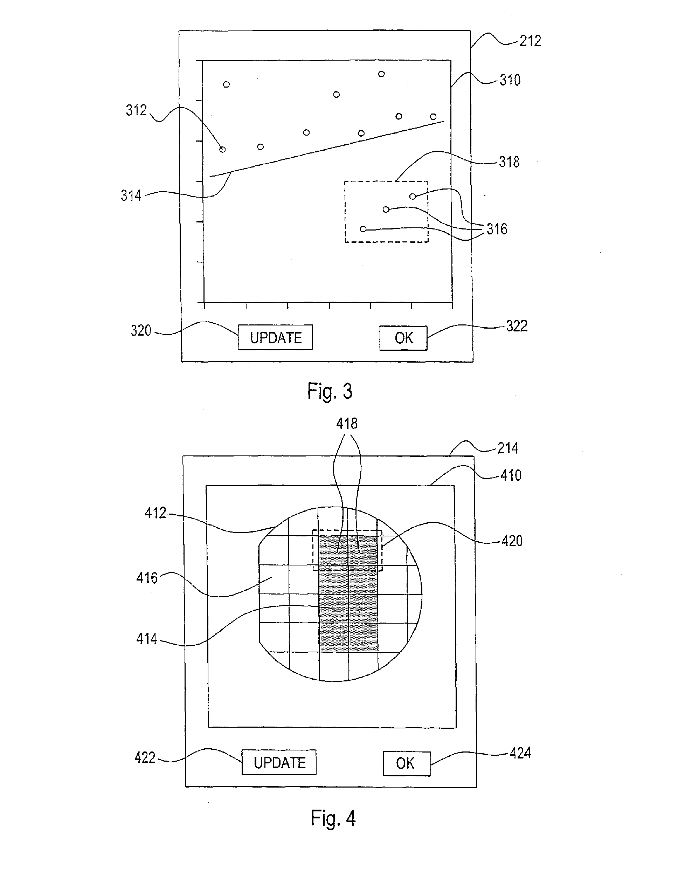

As shown in Figure 3, graph display device 310 and buttons 320 and 322 for various operations are displayed on graph display window 212. A scatter plot is displayed as an example on graph display device 310 here. The open circles (e.g., 312 and 316) in this scatter diagram represent data and straight line 314 represents the regression curve. Incidentally, this screen is an example. Scatter plots do not necessarily represent regression curves.

As shown in Figure 4, map display device 410 and buttons 422 and 424 for various functions are displayed on map display window 214. Here a wafer map is displayed as an example on map display device 410. The dies that have the data displayed on graph display window 212 are displayed as dies with a speckled display (e.g., 414 and 418) on wafer 412. Dies that do not have the displayed data are displayed as blank dies (e.g., 416).

The operation of the present invention will be described using Figures 1 through 6. The operator decides to display Figures 3 and 4 on the screen in Figure 2 based on the results of graphing and mapping the data that were initially extracted. Here, the operator is interested in the position information of data in the map display that correspond to the three data points 316 that have slipped down in the graph display in Figure 3. In this case, the operator drags the mouse to select these three data points 316 by regional specification. One or multiple data points can be included in this region. This method of regional specification uses known window operation methods. For instance, a variety of input methods, such as clicking data or clicking data while holding down control keys on the keyboard, etc., can also be used as substitute input methods.

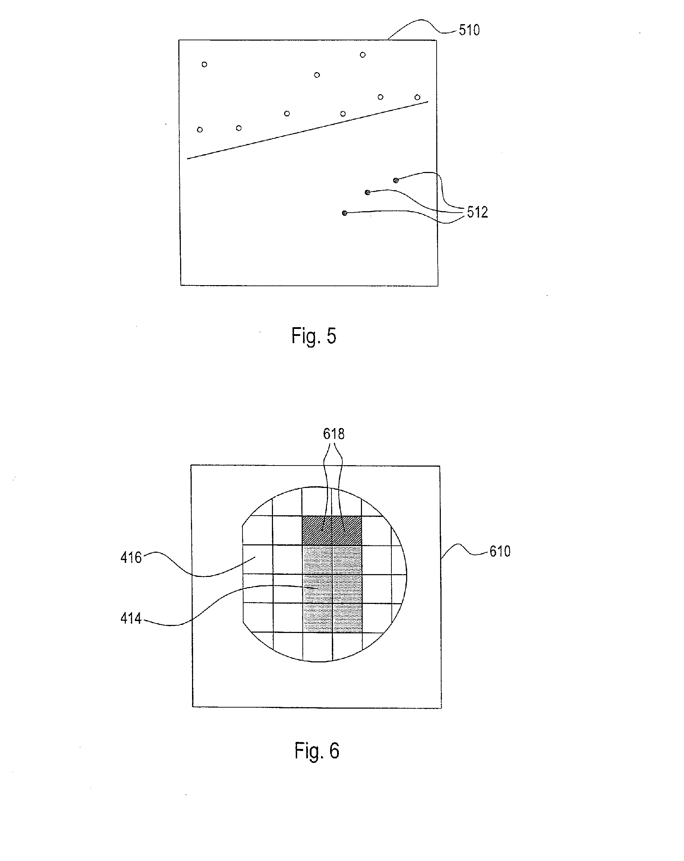

With respect to displaying this regional specification, graph element selection device 116 in Figure 1 determines the data that have been stored and the instruction position of the pointing device, etc., in conjunction with memory 110 and input device 112 and controls graph display device 122 in accordance with these results to display boundary 318 of a rectangular region as the mouse is being dragged. The operator finishes dragging the mouse and graph element selection device 116 controls graph display device 124 so that data within the region that has been regionally specified are displayed in highlighted form so that these are seen as the three data points 512 in Figure 5. Furthermore, graph element selection device 116 controls map display device 124 this time and, as shown in Figure 6, the dies corresponding to the three data 512 points that were selected, that is, the two dies 618 for which the three data 512 points have been determined here, are displayed in highlighted form using a shading pattern.

Incidentally, a shading pattern was used for displaying in highlighted form in Figures 5 and 6, but it goes without saying that those skilled in the art can substitute a variety of methods, as previously mentioned.

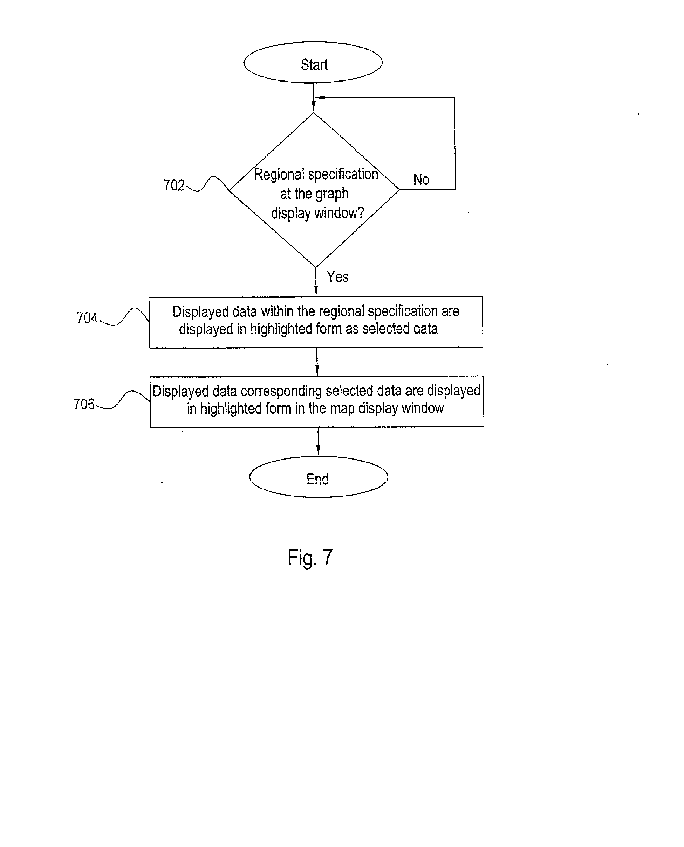

The above-mentioned operation is shown in Figure 7 as a flow chart of graph element selection device 116. Graph element selection device 116 determines whether or not there has been regional selection at graph display window 212 (step 702), and, if there has been regional selection (YES), all displayed data within the regional specification are displayed in highlighted form as data that have been selected (step 704), and displayed data corresponding to the data that have been selected are displayed in highlighted form in map display window 214 (step 706). Nothing is done in step 702 if there has not been a regional selection (NO).

Thus, by using the present invention, the operator can easily know the position of dies in the wafer map display that correspond to the graph display elements that pose a problem in the details displayed by the graph and therefore, problems can be efficiently solved during the analysis of semiconductor production processes, particularly the analysis of defects.

The operation of data analysis apparatus 100 will be explained for the case wherein the operator would like to know the distribution of data displayed by a graph that correspond to several dies displayed on a wafer map. The operator decides to display Figures 3 and 4, which will be displayed on the screen in Figure 2 based on the results of graphing and mapping the data that were initially extracted. The operator selects two dies 418 in Figure 4 as the dies for which the operator wishes to know the corresponding graph display distribution. In order to select these dies, the mouse is dragged to include the subject dies within the region. During this dragging, the boundary of a rectangle is represented on wafer map 410 by broken line 420. The operator finishes dragging the mouse and confirms the selection. The two dies that have been selected are displayed in highlighted form by a shading pattern such as that shown by 618 in Figure 6.

As pointed out in a previous example, it is possible to use various substitute methods as a method for specifying the dies.

Map element selection device 118 controls graph display device 122 this time and, as shown in Figure 5, the data that have been tested for two dies 618 that have been selected, that is, the three data points 512 here, are displayed in highlighted form using a shading pattern.

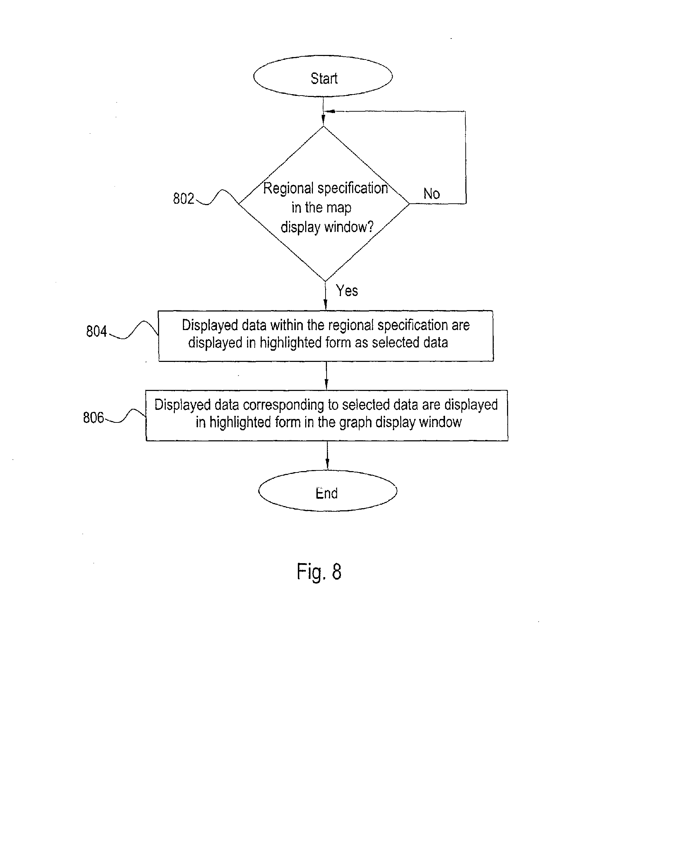

The above-mentioned operation is shown in Figure 8 as a flow chart of map element selection device 118. Map element selection device 118 determines whether there has been regional selection at map display window 214 (step 802) and if there has been regional selection (YES), all displayed data within the regional specification are displayed in highlighted form as data that have been selected (step 804), and displayed data corresponding to the data that have been selected are displayed in highlighted form in graph display window 212 (step 806). Moreover, nothing is done in step 802 if there has not been a regional selection (NO).

Embodiments of the present invention were described. By means of the above-mentioned embodiments, when the operator has finished selecting the desired data on the graph display device, or has finished selecting the desired map display elements on the map display device, the corresponding elements on the position display device or graph display device are immediately displayed in highlighted form in response. In contrast to this, by means of a different embodiment, a display in highlighted form that corresponds to the display of another display device is performed when the UPDATE button (320 or 422) for display renewal in the display device is pushed once the above-mentioned selection has been completed.

As previously mentioned, when the present invention is used, it is possible to present a data analysis apparatus with which the tendency of test data can be easily known in relationship to the tendency of the position on the wafer.

## Claims

1. A data analysis apparatus (100) for semiconductor test data, comprising:
a graph display device (122) that displays a graph of data;
a map display device (124) that displays a map pertaining to a test position of said data; and
a graph element selection device (116) for selecting at least a portion of said graph of said data, wherein a portion of said map corresponding to said selected portion of said graph of said data is displayed in highlighted form.

2. A data analysis apparatus (100) for semiconductor test data, comprising:
a graph display device (122) that displays a graph of data;
a map display device (124) that displays a map pertaining to a test position of said data; and
a map element selection device (118) for selecting at least a portion of said map of said data, wherein a portion of said graph of said data corresponding to said selected portion of said map of said data is displayed in highlighted form.

3. The data analysis apparatus (100) according to claim 1, further comprising:
a map element selection device (118) for selecting at least a portion of said map of said data, wherein a portion of said graph of said data corresponding to said selected portion of said map of said data is displayed in highlighted form.

4. The data analysis apparatus (100) according to claim 1, wherein said graph of said data is at least one of a format selected from a group consisting of: a scatter plot, a folding line graph, a line graph, a bar graph, a circle graph, and a cumulative distribution plot.

5. The data analysis apparatus (100) according to claim 2, wherein said graph of said data is at least one of a format selected from the group consisting of: a scatter plot, a folding line graph, a line graph, a bar graph, a circle graph, and a cumulative distribution plot.

6. A data analysis apparatus (100) according to claim 1, wherein said map is at least one of a format selected from the group consisting of: a wafer map and a die map.

7. A method for analysing semiconductor test data, comprising the steps of:
displaying a graph of data;
displaying a map pertaining to a test position of said data; and
selecting at least a portion of said graph of said data, and displaying a portion of said map corresponding to said selected portion of said graph in highlighted form.

8. A method for analysing semiconductor test data, comprising the steps of:
displaying a graph of data;
displaying a map pertaining to a test position of said data; and
selecting at least a portion of said map of said data, and displaying a portion of said graph of said data corresponding to said selected portion of said data in highlighted form.

9. The method for analysing semiconductor test data according to claim 7, further comprising the step of:
selecting at least a portion of said map of said data, and displaying a portion of said graph of said data corresponding to said selected portion of said map of said data in highlighted form.
